# EUROPÄISCHE PATENTSCHRIFT

(11) **EP 3 256 618 B1**
(45) Veröffentlichungstag und Bekanntmachung des Hinweises auf die Patenterteilung: **08.01.2020**
(21) Anmeldenummer: 16705476.6
(22) Anmeldetag: 15.02.2016
(51) Int. Cl.: C23C 14/56, C23C 16/54

(54) **VERFAHREN ZUM BETRIEB EINER INLINE-BESCHICHTUNGSANLAGE UND INLINE-BESCHICHTUNGSANLAGE**
METHOD FOR OPERATING AN INLINE COATING SYSTEM AND INLINE COATING SYSTEM
PROCÉDÉ POUR FAIRE FONCTIONNER UNE INSTALLATION DE REVÊTEMENT EN LIGNE ET INSTALLATION DE REVÊTEMENT DE LIGNE

(30) Priorität: 13.02.2015 DE 102015001706
(43) Veröffentlichungstag der Anmeldung: 20.12.2017
(73) Patentinhaber: Bühler Alzenau GmbH, 63755 Alzenau (DE)
(72) Erfinder: SCHREIBER, Udo, 63637 Jossgrund (DE); WEGENER, Ingo, 63755 Alzenau (DE); TRUBE, Jutta, 63776 Mömbris (DE)
(74) Vertreter: Vossius & Partner Patentanwälte Rechtsanwälte mbB
(86) Internationale Anmeldenummer: PCT/EP2016/053187
(87) Internationale Veröffentlichungsnummer: WO 2016/128581

(56) Entgegenhaltungen:
- WO-A1-84/03195
- WO-A1-85/04071
- WO-A1-2009/004048
- NL-A- 8 300 443

## Beschreibung

Die Erfindung betrifft ein Verfahren und eine Inline-Beschichtungsanlage mit den Merkmalen der unabhängigen Patentansprüche,

Inline-Beschichtungsanlagen sind beispielsweise für die Beschichtung flächiger Substrate, wie z.B. Glassubstrate, Kunststoff- oder Metallsubstrate, Substrate für Displays, Wafer, usw. bekannt. Eine als 3-Kammer-Vakuumbeschichtungsanlage bezeichnete Ausführungsform umfasst eine Einschleuskammer zum Einschleusen der Substrate in eine Prozesskammer, eine Ausschleuskammer zum Ausschleusen der Substrate aus der Prozesskammer, sowie eine Transporteinrichtung zum Bewegen der Substrate entlang eines Transportpfades. Anstelle einer Prozesskammer können auch mehrere Prozesskammern vorgesehen sein. Eingangsseitig und/oder ausgangsseitig können eine oder mehrere Prozesskammern auch Transferbereiche aufweisen.

Die bekannten Anlagen sind für die Bearbeitung von Substraten mit bestimmter Größe ausgelegt und dimensioniert, wobei meistens zur Bearbeitung von Substraten mit von dieser bestimmten Größe abweichenden Größe (Überlänge) Anlagen mit entsprechend größeren Kammern eingesetzt werden müssen.

Aus der EP 1 571 234 B1 ist es bekannt eine Anlage, die aus 2 n + 1 Kammern besteht, wobei n eine ganze Zahl größer oder gleich 2 ist, derartig zu betreiben, dass auch Substrate mit Überlänge bearbeitet werden können. In einer 5-Kammer- Anlage schließt an eine Einschleuskammer eine Pufferkammer an, an die eine Prozesskammer anschließt, an die eine weitere Pufferkammer anschließt, an die eine Ausschleuskammer anschließt. Zwischen den Kammern sind Tore vorgesehen, die geöffnet oder geschlossen werden können, wobei die Einschleuskammer, die Pufferkammer und die Ausschleuskammer als gleichartige Module für die Aufnahme von Substraten bis zu einer vorgegebenen maximal Größe ausgebildet sind. Für die Beschichtung von Substraten, die länger als die Module sind, wird das Tor zwischen der Einschleuskammer und der Pufferkammer sowie das Tor zwischen der Pufferkammer und der Ausschleuskammer geöffnet. Dabei werden die Druckverhältnisse der Pufferkammern und der Einschleus-bzw. Ausschleuskammer aneinander angepasst, wobei die Pumpprogramme für die Einschleuskammer und die erste Pufferkammer bzw. die zweite Pufferkammer und die Ausschleuskammer von Atmosphärendruck auf beispielsweise 0,05 mbar gemeinsam abgepumpt werden. Das bekannte Verfahren ermöglicht es Substrate mit Überlänge zu bearbeiten, wobei jedoch die Einschleuszeit und damit die gesamte Zykluszeit der Anlage nachteilig verlängert wird.

Aus der WO 2009/000813 ist ferner ein Schleusen eines Substrates in eine und aus einer 3 Kammer - Vakuumbeschichtungsanlage bekannt, bei dem ein Schleusensystem gebildet wird durch eine Schleusenkammer und einer an die Schleusenkammer angrenzende Transferkammer, mit einem die Transferkammer zur angrenzenden Prozesskammer vakuumdicht schließenden Schleusenventil. Während der Schleusung wird die Transferkammer mit der Schleusenkammer verbunden und ein Schleusentor zwischen Transferkammer und Schleusenkammer geöffnet, solange sich das Substrat in der Schleusenkammer befindet. Eine derartige Beschichtungsanlage ist dafür geeignet, flexibel auch solche Substrate zu beschichten, deren Längen die Länge einer Schleusenkammer übertrifft. Die Transferkammer weist an dem an die Schleusenkammer angrenzenden Ende einen Durchgang auf, dessen Querschnitt eine Verengung des Kammerquerschnitts in Transportrichtung betrachtet darstellt. Ferner weist die Transferkammer eine Ausführöffnung auf, in der ein im Vergleich zur bekannten 3-Kammer-Anlage zusätzliches Schleusenventil angeordnet ist, sodass die Prozesskammer von der Transferkammer vakuumtechnisch zu trennen ist und auch bei atmosphärischem Druck in der Transferkammer das Prozessvakuum in der Prozeßkammer aufrechterhalten werden kann. Im Betrieb der Anlage wird das Anlagentor geöffnet und das Substrat in das Schleusensystem transportiert. Nach dem Schließen des Anlagentors wird der Druck in dem verbundenen Volumen auf einen Feinvakuumdruck abgesenkt. Zur Effektivierung des Betriebs der Vakuumbeschichtungsanlage wird vorgeschlagen über die Einfuhröffnung oder die Ausfuhröffnung einen Druckgradienten in dem verbundenen Volumen einzustellen, also den Druckausgleich zwischen der Transferkammer und der Schleusenkammer zu vermindern.

Aus der WO 85/04071 ist bereits eine Installation für die Vakuumbehandlung von Substraten bekannt, welche mit einem Vakuummodul, in dem die Behandlung der Substrate unter Vakuum stattfindet, einem Druckreduktionsmodul, beinhaltend Gattermittel, in denen ein Druckabfall von Atmosphärendruck einem Vakuum stattfindet und einem Druckerhöhungsmodul, beinhaltend Gattermittel, in denen eine Druckerhöhung von einem Vakuum zu einem Atmosphärendruck erfolgt. Die Gattermittel beinhalten ein Eintrittsportal und mit einer in einer zugeordneten Kammer positionierten Ventilplatte und ein Austrittsportal mit einer in der zugeordneten Kammer positionierten weiteren Ventilplatte. Die Ventilplatte des Eintrittsportals weist eine fest vorgegebene Öffnung auf, durch die ein Substrat bewegt werden kann.

Aufgabe der vorliegenden Erfindung ist es, ein Verfahren zum Betrieb einer Inline-Beschichtungsanlage und eine Inline-Beschichtungsanlage zur Ausführung des Verfahrens anzugeben, die es ermöglichen, die Einschleuszeit und die gesamte Zykluszeit der Anlage zu verringern.

Die Aufgabe wird mit den Merkmalen der unabhängigen Patentansprüche gelöst. Vorteilhafte Ausführungen und Ausführungsformen und Weiterentwicklungen der Erfindung sind in den abhängigen Ansprüchen zusammengefaßt.

Das erfindungsgemäße Verfahren bezieht sich auf den Betrieb einer Inline-Beschichtungsanlage die eine Einschleuskammer mit einem Einschleustor umfasst, sowie eine an die Einschleuskammer anschließende ersten Pufferkammer, die mittels eines ersten Schleusentors von der Einschleuskammer abtrennbar ist, eine an die erste Pufferkammer anschließende Prozesskammer, die mittels eines zweiten Schleusentors von der Pufferkammer abtrennbar ist, eine an die Prozesskammer anschließenden zweiten Pufferkammer, die mittels eines dritten Schleusentors von der Prozesskammer abtrennbar ist, eine an die zweite Pufferkammer anschließende Ausschleuskammer mit einem Ausgangstor, die mittels eines vierten Schleusentors von der zweiten Pufferkammer abtrennbar ist, wobei die Einschleuskammer, die Pufferkammer, die Pufferkammer und die Ausschleuskammer als Modul für die Aufnahme von Substraten bis zu einer vorgegebenen Größe ausgebildet sind.

Die Substrate werden, wie an sich bekannt ist, für die Beschichtung von der Einschleusskammer durch die erste Pufferkammer zur Prozesskammer und von der Prozesskammer durch die zweite Pufferkammer zur Ausschleuskammer transportiert.

Das erfindungsgemäße Verfahren zeichnet sich dadurch aus, dass die erste Pufferkammer eine Spaltschleuseneinrichtung mit zumindest einer Spaltblende aufweist, mittels der innerhalb der ersten Pufferkammer ein Druckgradient zwischen dem Druck in dem Bereich des zweiten Schleusentors und dem Druck in dem Bereich des ersten Schleusentors eingestellt wird. Es kann bei geöffnetem ersten Schleusentor der Druckgradient zwischen dem Druck in dem Bereich des zweiten Schleusentors und dem Druck in dem Bereich des ersten Schleusentors eingestellt werden. Ebenfalls kann bei geschlossenem ersten Schleusentor der Druckgradient zwischen dem Druck in dem Bereich des zweiten Schleusentors und dem Druck in dem Bereich des ersten Schleusentors eingestellt werden.

Das erfindungsgemäße Verfahren zeichnet sich dadurch aus, dass auch bei geöffneten Einschleustor und geöffnetem ersten Schleusentor durch Betrieb von an die Schleusenkammer angeschlossenen Pumpen innerhalb der Pufferkammer ein Druckgradient zwischen dem Druck in dem Bereich des zweiten Schleusentors und dem Druck in dem Bereich des ersten Schleusentors aufrechterhalten wird. Vorzugsweise wird die erste Pufferkammer kontinuierlich evakuiert, vorzugsweise mit Ausnahme einer Belüftungsphase der Schleusenkammer.

Die Spaltschleuseneinrichtung umfasst zumindest eine Spaltblende, vorzugsweise eine Mehrzahl von Spaltblenden, die in Längsrichtung der Kammer in Reihe geschaltet sind. Die Spaltschleuseneinrichtung ermöglicht eine Druckentkopplung zwischen Schleusenkammer und Prozesskammer sowie die Schaffung eines Druckgradienten innerhalb der Pufferkammer. Bei mehreren Spaltblenden ist ein zunehmender Verlauf des Druckgradienten vorteilhaft in Längsrichtung der Kammer entsprechend den Positionen der Spaltblenden realisiert. Vorteilhaft wird durch die Spaltschleuseneinrichtung das Kammervolumen vermindert, besonders vorteilhaft minimiert.

Die Spaltschleuseneinrichtung ermöglicht es, zusammen mit dem Druckgradienten, die Schleusenkammer und die Prozesskammer besser druckmäßig zu entkoppeln, als es beispielsweise aus der EP 1 571 234 B1 und der WO 2009/000813 bekannt ist, und damit die Einschleuszeit, d.h. die Zeit für den Transport eines Substrats vom Eintritt des Substrats in die Schleusenkammer bis zum Eintritt in die Prozesskammer zu vermindern.

Vorteilhaft kann bei der Beschichtung von Substraten mit einer Länge kleiner als die Länge der Module ein Drucktriggerpunkt für den Druck in der Schleusenkammer, zu dem das zweite Schleusentor geöffnet wird, höher gesetzt werden als beim Betrieb ohne Druckgradient und damit die Einschleuszeit reduziert und die aus der Schleusenkammer abzupumpende Luftmenge ebenfalls reduziert werden. Im Stand der Technik ist, also ohne Verwendung eines Druckgradienten beispielsweise ein Evakuieren der Einschleuskammer bis zu einem Druck von etwa 15 mbar und ein Evakuieren der Pufferkammer auf 10** -2 mbar üblich. Bei dem erfindungsgemäßen Verfahren braucht zum Einschleusen, bei gleichlanger Kammer wie im Stand der Technik, die Einschleuskammer nur bis zu einem Druck von beispielweise etwa 36 mbar evakuiert werden, , ohne dass im Übrigen das Pumpprogamm oder die Pumpstände gegenüber dem Stand der Technik geändert sind. Damit lässt sich mit dem erfindungsgemäßen Verfahren beispielsweise eine um 15% geringere Einschleuszeit als im Stand der Technik erreichen.

Eine weitere Ausführungsform des Verfahrens zeichnet sich dadurch aus, dass für die Beschichtung von Substraten, die kleiner als die Module sind, das erste Schleusentor geschlossen ist, das Einschleustor geöffnet wird, ein Substrat in die Einschleuskammer transportiert wird, das Einschleustor geschlossen wird, die Einschleuskammer bis zu einem vorgegebenen Druck evakuiert wird, das erste Schleusentor geöffnet wird, das Substrat in die Pufferkammer befördert wird, wobei in der Pufferkammer im Bereich des zweiten Schleusentores ein niedrigerer Druck eingestellt wird als in der Einschleuskammer ,das erste Einschleustor wieder geschlossen wird, die Pufferkammer bis zu einem Druck evakuiert wird, der etwa dem Druck der Prozesskammer entspricht und das zweite Schleusentor geöffnet wird, das Substrat in die Prozesskammer transportiert und das zweite Schleusentor geschossen und das Substrat in der Prozesskammer bearbeitet wird.

Eine weitere Ausführungsform des Verfahrens zeichnet sich dadurch aus, dass für die Beschichtung von Substraten, die größer als die Module sind, das Einschleustor und das erste Schleusentor geöffnet werden, ein Substrat wird in die Einschleuskammer und die Pufferkammer transportiert, das Einschleustor wird geschlossen, die Einschleuskammer wird bis zu einem vorgegebenen Druck evakuiert, die Pufferkammer wird bis zu einem vorgegebenen Druck im Bereich des zweiten Schleusentores evakuiert, der etwa dem Druck der Prozesskammer entspricht und das zweite Schleusentor wird geöffnet und das Substrat in die Prozesskammer transportiert, um dort bearbeitet zu werden. Im Unterschied zum aus der EP 1 571 234 B1 bekannten Stand der Technik werden für die Beschichtung von überlangen Substraten die Druckverhältnisse der Pufferkammer und der Einschleuskammer nicht aneinander angepasst, womit die Zykluszeit verringert werden kann.

Eine weitere Ausführungsform des Verfahrens zeichnet sich dadurch aus, dass das erste Schleusentor geschlossen wird, nachdem das Substrat mit seiner hinteren Kante das erste Schleusentor passiert hat und die hintere Kante das zweite Schleusentor noch nicht passiert hat, so dass das Evakuieren der ersten Pufferkammer effizienter erfolgen kann.

Eine weitere Ausführungsform des Verfahrens zeichnet sich dadurch aus, dass das zweite Schleusentor geschlossen wird, nachdem das Substrat mit seiner hinteren Kante das zweite Schleusentor passiert hat, so dass das Evakuieren der Prozesskammer effizienter erfolgen kann.

Eine weitere Ausführungsform des Verfahrens zeichnet sich dadurch aus, dass das erste Schleusentor geöffnet wird, nachdem das Substrat mit seiner hinteren Kante das zweite Schleusentor passiert hat, so dass ein weiteres Substrat schneller in die erste Pufferkammer transportiert werden kann.

Eine weitere Ausführungsform des Verfahrens zeichnet sich dadurch aus, dass auch bei geöffnetem Einschleustor und erstem Schleusentor durch Betrieb von an die Schleusenkammer angeschlossenen Pumpen innerhalb der Pufferkammer in dem Bereich des zweiten Schleusentors ein Druck von weniger als 500 mbar, vorzugsweise weniger als 600 mbar bei Atmosphärendruck in der Schleusenkammer aufrechterhalten wird, womit das Prozessvakuum in der Prozesskammer mit höherer Sicherheit aufrechterhalten und gegen Kontaminationen geschützt werden kann.

Eine weitere Ausführungsform des Verfahrens zeichnet sich dadurch aus, dass innerhalb der Pufferkammer ein Druckgradient zwischen dem Druck in dem Bereich des zweiten Schleusentors und dem Druck in dem Bereich des ersten Schleusentors eingestellt wird, bei dem der Druck in dem Bereich des zweiten Schleusentors mindestens um einen Faktor 2 mal kleiner als Druck in dem Bereich des ersten Schleusentors ist, womit das Prozessvakuum in der Prozesskammer mit höherer Sicherheit aufrechterhalten und gegen Kontaminationen geschützt werden kann. Vorzugsweise kann ein weit höherer Faktor als 2, beispielsweise von 10 oder 200 am Ende des Abpumpzyklus vorgesehen sein.

Es versteht sich, dass entsprechend dem oben dargestellten Vorgehen beim Einschleusen von Substraten auch beim Ausschleusen von Substraten vorgegangen werden kann.

Bei einer erfindungsgemäßen Inline-Beschichtungsanlage, welche eine Einschleuskammer, mit einem Einschleustor und eine an die Einschleuskammer anschließenden ersten Pufferkammer, die mittels eines ersten Schleusentors von der Einschleuskammer abtrennbar ist aufweist, ist ferner eine an die erste Pufferkammer anschließende Prozesskammer, die mittels eines zweiten Schleusentors von der Pufferkammer abtrennbar ist, eine an die Prozesskammer anschließende zweite Pufferkammer, die mittels eines dritten Schleusentors von der Prozesskammer abtrennbar ist, eine an die zweite Pufferkammer anschließenden Ausschleuskammer mit einem Ausgangstor, die mittels eines vierten Schleusentors von der zweiten Pufferkammer abtrennbar ist, wobei die Einschleuskammer, die Pufferkammer, die Pufferkammer und die Ausschleuskammer als Modul für die Aufnahme von Substraten bis zu einer vorgegebenen Größe ausgebildet sind vorgesehen, wobei die Substrate für die Beschichtung von der Einschleuskammer durch die erste Pufferkammer zur Prozesskammer und von der Prozesskammer durch die zweite Pufferkammer zur Ausschleuskammer transportiert werden. Die Anlage zeichnet sich dadurch aus, dass die erste Pufferkammer eine Spaltschleuseneinrichtung mit zumindest einer Spaltblende aufweist, mittels der bei geöffnetem ersten Schleusentor ein Druckgradient zwischen dem Druck in dem Bereich des zweiten Schleusentors und dem Druck in dem Bereich des ersten Schleusentors einstellbar ist. Ebenfalls kann bei geschlossenem ersten Schleusentor ein Druckgradient zwischen dem Druck in dem Bereich des zweiten Schleusentors und dem Druck in dem Bereich des ersten Schleusentors einstellbar sein. Die erfindungsgemäße Inline-Beschichtungsanlage zeichnet sich dadurch aus, dass auch bei geöffneten Einschleustor und geöffnetem ersten Schleusentor durch Betrieb von an die Schleusenkammer angeschlossenen Pumpen innerhalb der Pufferkammer ein Druckgradient zwischen dem Druck in dem Bereich des zweiten Schleusentors und dem Druck in dem Bereich des ersten Schleusentors aufrechterhalten werden kann.

Die erfindungsgemäße Anlage weist entsprechende Vorteile wie das erfindungsgemäße Verfahren auf.

Es versteht sich, dass auch die Dimensionierungen der entsprechenden Kammern für das Ausschleusen entsprechend beim Ausschleusen wählbar und von der Erfindung umfasst sind. Im Folgenden wird die Erfindung anhand von Ausführungsbeispielen der Figuren näher beschrieben, aus denen sich auch weitere Aspekte und Vorteile der Erfindung ergeben.

Es zeigen:
- Fig. 1:: einen Schnitt in einer Draufsicht einer aus dem Stand der Technik bekannten 5-Kammer-Anlage
- Fig. 2:: einen Schnitt in einer Draufsicht einer erfindungsgemäßen Inline-Beschichtungsanlage.

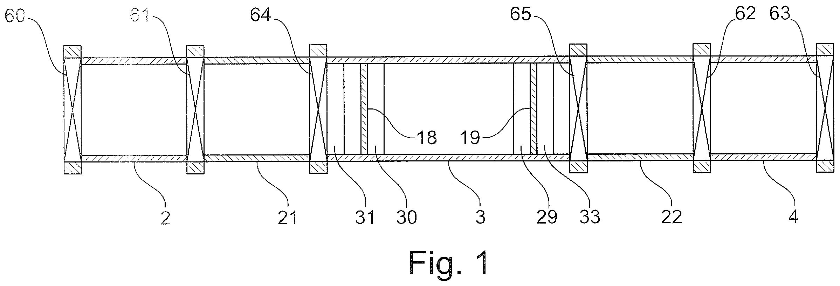

Fig. 1 zeigt eine bekannte 5-Kammer-Beschichtungsanlage mit einer Einschleuskammer 2, einer Pufferkammer 21, einer Prozesskammer 3 mit einer Transferkammer 31, die eine Spaltblende 30 mit einer Spaltblendenaufhängung 18 sowie eine Transferkammer 33 mit einer Spaltblende 29 und einer Spaltblendenaufhängung 19 aufweist. Die eigentliche Prozesskammer 3 ist üblicherweise aus vielen einzelnen, gleich großen Segmenten zusammengesetzt, wobei je nach Anforderung so viele Segmente aneinander gehängt werden, dass darin die jeweiligen Aufgaben durchgeführt werden können. An die Prozesskammer 3 schließt sich eine Pufferkammer 22 und an diese eine Ausschleuskammer 4 an. Zum Einschleusen der Substrate weist die Einschleuskammer 2 ein Schleusentor 60 auf. Einschleuskammer 2 und Pufferkammer 21 sind durch ein Schleusentor 61 vakuumtechnisch voneinander trennbar. Die Pufferkammer 21 und die Prozesskammer 3 sind durch ein Schleusentor 64 vakuumtechnisch voneinander trennbar. Die Prozesskammer 3 und die Pufferkammer 2 sind durch ein Schleusentor 65 voneinander trennbar, während Pufferkammer 22 und Ausschleuskammer 4 durch ein Schleusentor 62 voneinander trennbar sind. Die Ausschleuskammer 4 weist schließlich ein Tor 63 auf. In den Kammern 2, 21, 3, 22 und 4 befinden sich jeweils Transporteinrichtungen für Substrate. Die Kammern 2, 21, 3, 22 und 4 können alle durch Pumpen evakuiert werden.

Zum Einschleusen werden die Substrate bei der bekannten Anlage zunächst in die Einschleuskammer 2 eingeschleust, wobei der Druck in dieser auf ca. 15 mbar verringert wird. Danach erfolgt ein Umschleusen der Substrate in die Pufferkammer 21 wobei der Druck weiter verringert wird auf ein Niveau, das nahe dem Druck in der Prozesskammer 3 ist. Da in den Kammern 2 und 21 das Abpumpen in beiden Kammern parallel erfolgen kann, kann die Zykluszeit gegenüber dem Betrieb einer 3-Kammer-Anlage reduziert werden.

Im Sonderbetrieb für überlange Substrate wird die bekannte 5-Kammer-Anlage als 3-Kammer-Anlage betrieben, wobei die Kammern 2 und 21 geflutet werden. Dabei wird das Tor 60 geöffnet, wobei das Tor 61 immer offen bleibt. Ein Substrat wird dann in die Kammern 2 und 21 gefördert und das Tor 60 wieder geschlossen. Zum Bearbeiten von Substraten mit Überlänge werden also die Pumpprogramme für die beiden Kammern 2, 21 angepasst, so dass nur beide Kammern 2, 21 von Atmosphärendruck auf ca. 0,05 mbar abgepumpt werden. Bei der bekannten Anlage besteht der Pumpensatz der Kammer 2 aus Drehschieberpumpen, die von Atmosphärendruck herunterpumpen können. Der Pumpsatz der Kammer 21 enthält außer Drehschieberpumpen auch Rootspumpen, die erst ab ca. 7 mbar zugeschaltet werden können. Um die vergrößerte Einschleuskammer 2 und 21 auf ca. 0,05 mbar abzupumpen, werden beide Pumpsätze nacheinander verwendet und arbeiten nicht parallel wie im 5-Kammer-Standartbetrieb, wobei die Zykluszeit verlängert wird.

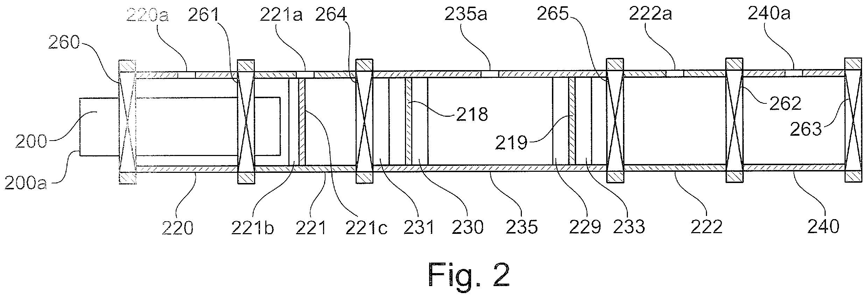

Fig. 2 zeigt eine erfindungsgemäße Inline-Beschichtungsanlage, welche eine Einschleuskammer 220, mit einem Einschleustor 260, einer an die Einschleuskammer 220 anschließenden ersten Pufferkammer 221, die mittels eines ersten Schleusentors 261 von der Einschleuskammer 220 abtrennbar ist, einer an die Pufferkammer 221 anschließenden Prozesskammer 235, die mittels eines zweiten Schleusentors 264 von der Pufferkammer 221 abtrennbar ist, einer an die Prozesskammer 235 anschließenden zweiten Pufferkammer 222, die mittels eines dritten Schleusentors 265 von der Prozesskammer 235 abtrennbar ist, einer an die zweite Pufferkammer 222 anschließenden Ausschleuskammer 240 mit einem Ausgangstor 263, die mittels eines vierten Schleusentors 262 von der zweiten Pufferkammer 222 abtrennbar ist, wobei die Einschleuskammer 220, die Pufferkammer 221, die Pufferkammer 222 und die Ausschleuskammer 240 als Modul für die Aufnahme von Substraten bis zu einer vorgegebenen Größe ausgebildet sind, wobei die Substrate 200 für die Beschichtung von der Einschleuskammer 220 durch die Pufferkammer 221 zur Prozesskammer 235 und von der Prozesskammer 235 durch die Pufferkammer 222 zur Ausschleuskammer 240 transportiert werden. In Figur 2 ist ein Substrat 200, das größer als die Module sind dargestellt, das in die Kammern 220 und 221 hineinragt. Es versteht sich, dass das Verfahren und die Anlage auch für die Beschichtung von Substraten geeignet und bestimmt, die kleiner als die Module sind.

Die Pufferkammer 221 weist eine Spaltschleuseneinrichtung mit zumindest einer Spaltblende 221b mit einer optionalen Spaltblendenaufhängung 221c auf. Vorzugsweise umfasst die Spaltschleuseneinrichtung zwei oder mehr Spaltblenden.

Die Prozesskammer 235 kann analog zu der aus dem Stand der Technik bekannten Prozesskammer 3 ausgebildet sein. Vorteilhaft weist die Prozesskammer 235 eine Transferkammer 231 mit einer Spaltblende 230 mit einer Spaltblendenaufhängung 218 sowie eine Transferkammer 233 mit einer Spaltblende 229 und einer Spaltblendenaufhängung 219 auf.

Zum Evakuieren der Kammern sind Pumpanschlüsse 220a, 221a, 235a, 222a und 240a sowie damit verbundene, in Figur 2 nicht dargestellte Pumpen vorgesehen. Weitere Pumpanschlüsse sind denkbar. Vorzugsweise umfasst der Pumpensatz der Kammer 220 und/oder der Kammer 240 Drehschieberpumpen, die von Atmosphärendruck herunterpumpen können. Der Pumpensatz der Kammer 221 und/oder der Kammer 222 enthält neben vorzugsweise Drehschieberpumpen vorzugsweise auch Rootspumpen, die auf ein niedrigeres Druckniveau evakuieren können.

Zumindest die Kammer 220 weist Belüftungseinrichtungen (nicht in Figur 2 dargestellt) auf. Es versteht sich, dass auch die weiteren Kammern 221, 235, 222 und 240 Belüftungseinrichtungen aufweisen können.

Die Kammern 220, 221, 235, 222 und 240 besitzen ferner Transporteinrichtungen für die Substrate und sind mit Steuereinrichtungen, insbesondere für den Pumpenbetrieb, den Transport der Substrate, das Öffnen und Schließen der Tore sowie für die Durchführung der Aufgaben innerhalb der Prozesskammer 235 ausgestattet.

Erfindungsgemäß wird auch bei geöffnetem ersten Schleusentor 261 mittels der Spaltschleuseneinrichtung ein Druckgradient zwischen dem Druck in dem Bereich des zweiten Schleusentors 264 und dem Druck in dem Bereich des ersten Schleusentors 261 eingestellt.

Der Druckgradient hat in dem Bereich des zweiten Schleusentors 264 einen niedrigeren Wert als in dem Bereich des ersten Schleusentors 261. Vorzugsweise ist in dem Bereich des zweiten Schleusentors 264 ein 2-fach niedrigerer Druck oder geringer als in dem Bereich des ersten Schleusentors 261 eingestellt. Besonders vorteilhaft ist es, wenn in dem Bereich des zweiten Schleusentors 264 ein 10- 20-, 30-, 40-, 50-, 60-, 70-, 80-, 90-fach niedrigerer Druck als in dem Bereich des ersten Schleusentors 261 eingestellt wird, zumindest zu einem Zeitpunkt zu dem das zweite Schleusentor 264 geöffnet wird. Es ist auch denkbar dass ein 100-, 150 -, 200- fach oder noch niedriger Druck in dem Bereich des zweiten Schleusentors 264 eingestellt wird, als in dem Bereich des ersten Schleusentors 261.

Der Druckgradient wird dynamisch während des zeitlichen Verlaufs des Einschleusprozesses des Substrats geändert, wobei er vorteilhaft zu Beginn des Einschleusprozesses geringer als zum Zeitpunkt des Umschleusens in die Prozesskammer 235, bzw. die Transferkammer 231 ist.

Die Werte, die der Druckgradient annimmt, hängen von der Pumpleistung und der Position und dem Leitwert der Pumpanschlüsse in der Pufferkammer 221 sowie der Ausgestaltung der Schlitzschleuseneinrichtung, insbesondere ihrer Länge und/oder dem Leitwert der einzelnen Spaltblenden bzw. dem Gesamtleitwert der Schlitzschleuseneinrichtung ab.

Die Pufferkammer 221 wird vorteilhaft kontinuierlich evakuiert, besonders vorteilhaft mit Ausnahme eines Zeitintervalls in dem die Einschleuskammer 220 belüftet wird und in dem die Evakuierung der Pufferkammer 221 durch die Pumpen unterbrochen wird. Vorteilhaft wird die Pufferkammer 221 auch bei geöffnetem Einschleustor 260 evakuiert.

Die Anlage wird vorzugsweise taktweise mit einer Zykluszeit betrieben, wobei die Zykluszeit die Zeit ist, die von der Einschleusung eines ersten Substrats in die Einschleuskammer 220 bis zur Einschleusung eines zweiten Substrats vergeht.

Es ist vorgesehen, dass für die Beschichtung von Substraten mit einer Länger kleiner als die Länge der Kammer-Module, das erste Schleusentor 261 geschlossen ist, das Einschleustor 260 geöffnet ist, ein Substrat in die Einschleuskammer 220 transportiert wird, das Einschleustor 260 geschlossen wird, die Einschleuskammer 220 bis zu einem vorgegebenen Druck evakuiert wird, das erste Schleusentor 261 geöffnet wird, das Substrat in die Pufferkammer 221 befördert wird, wobei in der Pufferkammer 221 im Bereich des Schleusentores 264 ein niedrigerer Druck eingestellt wird als in der Einschleuskammer 220, das erste Schleusentor 261 wieder geschlossen wird, die Pufferkammer 221 bis zu einem niedrigeren Druck evakuiert wird, dem sogenannten Transfer - Druck, der etwa dem Druck in der Transferkammer 231 der Prozesskammer 235 entsprechen kann. Dann wird das zweite Schleusentor 264 geöffnet, das Substrat in die Prozesskammer 235 transportiert, das zweite Schleusentor 264 geschossen und das Substrat in der Prozesskammer 235 bearbeitet.

Die Schleusenkammer 220 wird vor dem erneuten Öffnen des Einschleustors 260 auf einen Druck belüftet, der in etwa dem Atmosphärendruck entspricht, das Einschleustor 260 also bei Erreichen eines Atmosphärentriggerdrucks geöffnet.

Nach der Bearbeitung des Substrats in der Prozesskammer 235 wird das Substrat über die Kammern 222 und 240 aus der Anlage ausgeschleust, wobei es sich versteht, dass analog zu Kammer 221 auch in der Kammer 222 eine Spaltschleuseneinrichtung mit einer Spaltblende vorgesehen sein kann (in Figur 2 nicht dargestellt). Es kann dann beim Ausschleusen von Substraten analog wie beim Einschleusen von Substraten verfahren werden. Bei geöffnetem Schleusentor 262 kann mittels der Spaltschleuseneinrichtung ein Druckgradient zwischen dem Druck in dem Bereich des Schleusentors 265 und dem Druck in dem Bereich des Schleusentors 262 eingestellt werden. Der Druckgradient hat in dem Bereich des Schleusentors 265 einen niedrigeren Wert als in dem Bereich des Schleusentors 262.

Vorteilhaft wird die Pufferkammer 222 auch bei geöffnetem Ausschleustor 263 evakuiert.

Für die Beschichtung von Substraten 200, die größer als die Module sind, ist das Einschleustor 260 und das erste Schleusentor 261 geöffnet. Ein Substrat 200 wird in die Einschleuskammer 220 und die Pufferkammer 221 transportiert, das Einschleustor 260 wird geschlossen, die Einschleuskammer 220 wird bis zu einem vorgegebenen Druck evakuiert. Die Pufferkammer 221 wird im Bereich des zweiten Schleusentores 264 bis zu einem niedrigeren Druck evakuiert, dem sogenannten Transfer - Druck, der etwa dem Druck in der Transferkammer 231 der Prozesskammer 235 entsprechen kann. Dann wird das zweite Schleusentor 264 geöffnet und das Substrat 200 in die Prozesskammer 235 transportiert, um dort bearbeitet zu werden.

Es kann beim Ausschleusen von überlangen Substraten 200 analog wie beim Einschleusen von überlangen Substraten 200 verfahren werden.

Eine Ausführungsform der Erfindung zeichnet sich dadurch aus, dass das erste Schleusentor 261 geschlossen wird, nachdem das Substrat 200 mit seiner hinteren Kante 200a das erste Schleusentor 261 passiert hat und die hintere Kante 200a das zweite Schleusentor 264 noch nicht passiert hat.

Eine Ausführungsform der Erfindung zeichnet sich dadurch aus, dass das zweite Schleusentor 264 geschlossen wird, nachdem das Substrat 200 mit seiner hinteren Kante 200a das zweite Schleusentor 264 passiert hat.

Eine weitere Ausführungsform der Erfindung zeichnet sich dadurch aus, dass das erste Schleusentor 261 geöffnet wird, nachdem das Substrat 200 mit seiner hinteren Kante 200a das zweite Schleusentor 264 passiert hat und das Schleusentor 264 geschlossen wurde.

Die Schleusenkammer 220 wird vor dem erneuten Öffnen des Einschleustors 260, insbesondere für das Einschleusen eines neuen Substrats, auf einen Druck belüftet, der in etwa dem Atmosphärendruck entspricht, das Einschleustor 260 also bei Erreichen eines Atmosphärentriggerdrucks geöffnet. Das Belüften der Schleusenkammer 220 erfolgt frühestens wenn die hintere Kante 220a des Substrats 220 durch das Schleusentor 261 transportiert wurde und das Schleusentor 261 geschlossen wurde. Für den Fall, dass das Schleusentor 261 noch geöffnet ist, erfolgt die Belüftung erst, wenn das Schleusentor 264 geschlossen wurde.

Eine weitere Ausführungsform der Erfindung zeichnet sich dadurch aus, dass auch bei geöffneten Einschleustor 260 und erstem Schleusentor 261 durch Betrieb von an die Kammer 221 angeschlossenen Pumpen innerhalb der Pufferkammer 221 ein Druckgradient zwischen dem Druck in dem Bereich des zweiten Schleusentors 264 und dem Druck in dem Bereich des ersten Schleusentors 261 aufrechterhalten wird. Vorzugsweise kann vorgesehen sein, dass dann innerhalb der Pufferkammer 221 in dem Bereich des zweiten Schleusentors 264 ein Druck von etwa 400 mbar bis 750 mbar aufrechterhalten wird.

Es kann ferner vorgesehen sein, dass innerhalb der Pufferkammer 221 ein Druckgradient zwischen dem Druck in dem Bereich des zweiten Schleusentors 264 und dem Druck in dem Bereich des ersten Schleusentors 261 eingestellt wird, bei dem der Druck in dem Bereich des zweiten Schleusentors 264 mindestens 2 mal kleiner als Druck in dem Bereich des ersten Schleusentors 261 ist.

### Bezugszeichenliste

- 2: Einschleuskammer
- 3: Prozesskammer
- 4: Ausschleuskammer
- 18: Spaltblendenaufhängung
- 19: Spaltblendenaufhängung
- 21: Pufferkammer
- 22: Pufferkammer
- 29: Spaltblende
- 30: Spaltblende
- 31: Transferkammer
- 33: Transferkammer
- 60: Schleusentor
- 61: Schleusentor
- 62: Schleusentor
- 63: Schleusentor
- 64: Schleusentor
- 65: Schleusentor
- 200: Substrat
- 218: Spaltblendenaufhängung
- 219: Spaltblendenaufhängung
- 220: Einschleuskammer
- 220a: Pumpanschluss
- 221: Pufferkammer
- 221a: Pumpanschluss
- 221b: Spaltblende
- 221c: Spaltblendenaufhängung
- 222: Pufferkammer
- 222a: Pumpanschluss
- 229: Spaltblende
- 230: Spaltblende
- 231: Transferkammer
- 233: Transferkammer
- 235: Prozesskammer
- 240: Ausschleuskammer
- 240a: Pumpanschluss
- 260: Schleusentor
- 261: Schleusentor
- 262: Schleusentor
- 263: Schleusentor
- 264: Schleusentor
- 265: Schleusentor

## Patentansprüche

1. Verfahren zum Betrieb einer Inline-Beschichtungsanlage, welche aufweist
- eine Einschleuskammer (220), mit einem Einschleustor (260),
- eine an die Einschleuskammer (220) anschließende erste Pufferkammer (221), die mittels eines ersten Schleusentors (261) von der Einschleuskammer (220) abtrennbar ist,
- eine an die erste Pufferkammer (221) anschließende Prozesskammer (235), die mittels eines zweiten Schleusentors (264) von der Pufferkammer (221) abtrennbar ist,
- eine an die Prozesskammer (235) anschließende zweite Pufferkammer (222), die mittels eines dritten Schleusentors (265) von der Prozesskammer (235) abtrennbar ist,
- eine an die zweite Pufferkammer (222) anschließende Ausschleuskammer (240) mit einem Ausgangstor (263), die mittels eines vierten Schleusentors (262) von der zweiten Pufferkammer (222) abtrennbar ist, wobei die Einschleuskammer (220), die erste Pufferkammer (221), die zweite Pufferkammer (222) und die Ausschleuskammer (240) als Modul für die Aufnahme von Substraten bis zu einer vorgegebenen Größe ausgebildet sind,
wobei die Substrate (200) für die Beschichtung von der Einschleuskammer (220) durch die erste Pufferkammer (221) zur Prozesskammer (235) und von der Prozesskammer (235) durch die zweite Pufferkammer (222) zur Ausschleuskammer (240) transportiert werden,
**dadurch gekennzeichnet,**
**dass** die erste Pufferkammer (221) eine Spaltschleuseneinrichtung mit zumindest einer Spaltblende (221b) aufweist, mittels der bei geöffnetem oder geschlossenem ersten Schleusentor (261), innerhalb der ersten Pufferkammer (221) ein Druckgradient zwischen dem Druck in dem Bereich des zweiten Schleusentors (264) und dem Druck in dem Bereich des ersten Schleusentors (261) eingestellt wird und
**dass** auch bei geöffnetem Einschleustor (260) und geöffnetem ersten Schleusentor (261) durch Betrieb von an die Pufferkammer (221) angeschlossenen Pumpen innerhalb der Pufferkammer (221) ein Druckgradient zwischen dem Druck in dem Bereich des zweiten Schleusentors (264) und dem Druck in dem Bereich des ersten Schleusentors (261) aufrechterhalten wird.

2. Verfahren nach Anspruch 1, **dadurch gekennzeichnet, dass** für die Beschichtung von Substraten, die kleiner als die Module sind,
- das erste Schleusentor (261) geschlossen ist
- das Einschleustor (260) geöffnet ist
- ein Substrat in die Einschleuskammer (220) transportiert wird
- das Einschleustor (260) geschlossen wird
- die Einschleuskammer (220) bis zu einem vorgegebenen Druck evakuiert wird
- das erste Schleusentor (261) geöffnet wird
- das Substrat in die Pufferkammer (221) befördert wird, wobei in der Pufferkammer (221) im Bereich des Schleusentores (264) ein niedrigerer Druck eingestellt wird als in der Einschleuskammer (220)
- das erste Schleusentor (261) wieder geschlossen wird
- die Pufferkammer (221) bis zu einem Transfer - Druck evakuiert wird und das zweite Schleusentor (264) geöffnet wird
- das Substrat in die Prozesskammer (235) transportiert wird
- das zweite Schleusentor (264) geschlossen und das Substrat in der Prozesskammer (235) bearbeitet wird.

3. Verfahren nach Anspruch 1, **dadurch gekennzeichnet, dass** für die Beschichtung von Substraten, die größer als die Module sind
- das Einschleustor (260) und das erste Schleusentor (261) geöffnet werden
- ein Substrat in die Einschleuskammer (220) und die Pufferkammer (221) transportiert wird, wobei in der Pufferkammer (221) im Bereich des Schleusentores (264) ein niedrigerer Druck eingestellt wird als in der Einschleuskammer (220)
- das Einschleustor (260) geschlossen wird
- die Einschleuskammer (220) bis zu einem vorgegebenen Druck evakuiert wird
- die Pufferkammer (221) im Bereich des zweiten Schleusentores (264) bis zu einem Transfer - Druck evakuiert wird,
- das zweite Schleusentor (264) geöffnet und das Substrat (200) in die Prozesskammer (235) transportiert wird, um dort bearbeitet zu werden.

4. Verfahren nach Anspruch 3, **dadurch gekennzeichnet, dass** das erste Schleusentor (261) geschlossen wird, nachdem das Substrat (200) mit seiner hinteren Kante (200a) das erste Schleusentor (261) passiert hat und die hintere Kante (200a) das zweite Schleusentor (264) noch nicht passiert hat.

5. Verfahren nach Anspruch 4, **dadurch gekennzeichnet, dass** das zweite Schleusentor (264) geschlossen wird, nachdem das Substrat (200) mit seiner hinteren Kante (200a) das zweite Schleusentor (264) passiert hat.

6. Verfahren nach Anspruch 5, **dadurch gekennzeichnet, dass** das erste Schleusentor (261) geöffnet wird, nachdem das Substrat (200) mit seiner hinteren Kante (200a) das zweite Schleusentor (264) passiert hat.

7. Verfahren nach einem der vorhergehenden Ansprüche, **dadurch gekennzeichnet, dass** auch bei geöffnetem Einschleustor (260) und erstem Schleusentor (261) innerhalb der Pufferkammer (221) in dem Bereich des zweiten Schleusentors (264) ein Druck unterhalb des Atmosphärendrucks eingestellt wird.

8. Verfahren nach einem der vorhergehenden Ansprüche, **dadurch gekennzeichnet, dass** eine kontinuierliche Evakuierung der Pufferkammer (221) mittels von an die Pufferkammer (221) angeschlossenen Pumpen erfolgt.

9. Verfahren nach einem der vorhergehenden Ansprüche, **dadurch gekennzeichnet, dass** innerhalb der Pufferkammer (221) ein Druckgradient zwischen dem Druck in dem Bereich des zweiten Schleusentors (264) und dem Druck in dem Bereich des ersten Schleusentors (261) eingestellt wird, bei dem der Druck in dem Bereich des zweiten Schleusentors (264) mindestens 2 mal kleiner als der Druck in dem Bereich des ersten Schleusentors (261) ist.

10. Inline-Beschichtungsanlage, welche aufweist
- eine Einschleuskammer (220), mit einem Einschleustor (260),
- eine an die Einschleuskammer (220) anschließende erste Pufferkammer (221), die mittels eines ersten Schleusentors (261) von der Einschleuskammer (220) abtrennbar ist,
- eine an die erste Pufferkammer (221) anschließende Prozesskammer (235), die mittels eines zweiten Schleusentors (264) von der Pufferkammer (221) abtrennbar ist,
- eine an die Prozesskammer (235) anschließende zweite Pufferkammer (222), die mittels eines dritten Schleusentors (265) von der Prozesskammer (235) abtrennbar ist,
- eine an die zweite Pufferkammer (222) anschließende Ausschleuskammer (240) mit einem Ausgangstor (263), die mittels eines vierten Schleusentors (262) von der zweiten Pufferkammer (222) abtrennbar ist, wobei die Einschleuskammer (220), die erste Pufferkammer (221), die zweite Pufferkammer (222) und die Ausschleuskammer (240) als Modul für die Aufnahme von Substraten bis zu einer vorgegebenen Größe ausgebildet sind,
wobei die Substrate (200) für die Beschichtung von der Einschleuskammer (220) durch die erste Pufferkammer (221) zur Prozesskammer (235) und von der Prozesskammer (235) durch die zweite Pufferkammer (222) zur Ausschleuskammer (240) transportierbar sind,
**dadurch gekennzeichnet,**
**dass** die erste Pufferkammer (221) eine Spaltschleuseneinrichtung mit zumindest einer Spaltblende (221b) aufweist, mittels der bei geöffnetem oder geschlossenem ersten Schleusentor (261) ein Druckgradient innerhalb der ersten Pufferkammer (221) zwischen dem Druck in dem Bereich des zweiten Schleusentors (264) und dem Druck in dem Bereich des ersten Schleusentors (261) einstellbar ist, und
**dass** die Inline-Beschichtungsanlage an die Pufferkammer (221) angeschlossene Pumpen aufweist, wobei auch bei geöffnetem Einschleustor (260) und geöffnetem ersten Schleusentor (261) durch Betrieb der Pumpen innerhalb der Pufferkammer (221) ein Druckgradient zwischen dem Druck in dem Bereich des zweiten Schleusentors (264) und dem Druck in dem Bereich des ersten Schleusentors (261) aufrechterhalten werden kann.

## Claims

1. A method for operating an inline coating installation comprising
- an introduction chamber (220) with an insertion gate (260),
- a first buffer chamber (221) adjoining the introduction chamber (220), which can be separated from the introduction chamber (220) by means of a first insertion gate (261),
- a process chamber (235) adjoining the first buffer chamber (221), which can be separated from the buffer chamber (221) by means of a second insertion gate (264),
- a second buffer chamber (222) adjoining the process chamber (235), which can be separated from the process chamber (235) by means of a third insertion gate (265),
- a discharge chamber (240) adjoining the second buffer chamber (222) and having an outlet port (263), which can be separated from the second buffer chamber (222) by means of a fourth insertion gate (262), wherein the introduction chamber (220), the first buffer chamber (221), the second buffer chamber (222) and the discharge chamber (240) are designed as a module for receiving substrates up to a predetermined size,
wherein the substrates (200) for the coating are transported from the introduction chamber (220) through the first buffer chamber (221) to the process chamber (235) and from the process chamber (235) through the second buffer chamber (222) to the discharge chamber (240),
**characterized in that**
the first buffer chamber (221) has a gap sluice device with at least one slit diaphragm (221b) by means of which, when the first insertion gate (261) is open or closed, within the first buffer chamber (221) a pressure gradient is adjusted between the pressure in the region of the second insertion gate (264) and the pressure in the region of the first insertion gate (261) and
**in that** also when the insertion gate (260) is open and the first insertion gate (261) is open, a pressure gradient between the pressure in the region of the second insertion gate (264) and the pressure in the region of the first insertion gate (261) is maintained by operating pumps connected to the buffer chamber (221) within the buffer chamber (221).

2. The method according to claim 1, **characterized in that** for the coating of substrates which are smaller than the modules
- the first insertion gate (261) is closed,
- the insertion gate (260) is open,
- a substrate is transported into the introduction chamber (220),
- the insertion gate (260) is closed,
- the introduction chamber (220) is evacuated to a predetermined pressure,
- the first insertion gate (261) is opened,
- the substrate is conveyed into the buffer chamber (221), wherein in the buffer chamber (221), in the region of the insertion gate (264), a lower pressure is defined as in the introduction chamber (220),
- the first insertion gate (261) is closed again,
- the buffer chamber (221) is evacuated to a transfer pressure and the second insertion gate (264) is opened,
- the substrate is transported into the process chamber (235),
- the second insertion gate (264) is closed and the substrate is processed in the process chamber (235).

3. The method according to claim 1, **characterized in that** for the coating of substrates which are larger than the modules
- the insertion gate (260) and the first insertion gate (261) are opened,
- a substrate is transported into the introduction chamber (220) and the buffer chamber (221), wherein a lower pressure is set in the buffer chamber (221) in the region of the insertion gate (264) than in the introduction chamber (220),
- the insertion gate (260) is closed,
- the introduction chamber (220) is evacuated to a predetermined pressure,
- the buffer chamber (221) is evacuated to a transfer pressure in the region of the second insertion gate (264),
- the second insertion gate (264) is opened and the substrate is transported into the processing chamber (235) to be processed there.

4. The method according to claim 3, **characterized in that** the first insertion gate (261) is closed after the substrate (200) has passed the first insertion gate (261) with its rear edge (200a) and the rear edge (200a) has not yet passed the second insertion gate (264).

5. The method according to claim 4, **characterized in that** the second insertion gate (264) is closed after the substrate has passed the second insertion gate (264) with its rear edge (200a).

6. The method according to claim 5, **characterized in that** the first insertion gate (261) is opened after the substrate (200) has passed the second insertion gate (264) with its rear edge (200a).

7. The method according to any one of the preceding claims, **characterized in that** a pressure below the atmospheric pressure is set within the buffer chamber (221) in the region of the second insertion gate (264) also when the insertion gate (260) and the first insertion gate (261) are open.

8. The method according to any one of the preceding claims, **characterized in that** a continuous evacuation of the buffer chamber (221) takes place by means of pumps connected to the buffer chamber (221).

9. The method according to any one of the preceding claims, **characterized in that** within the buffer chamber (221) a pressure gradient is established between the pressure in the region of the second insertion gate (264) and the pressure in the region of the first insertion gate (261), wherein the pressure in the region of the second insertion gate (264) is at least two times smaller than the pressure in the region of the first insertion gate (261).

10. An inline coating installation comprising
- an introduction chamber (220) with an insertion gate (260),
- a first buffer chamber (221) adjoining the introduction chamber (220), which can be separated from the introduction chamber (220) by means of a first insertion gate (261),
- a process chamber (235) adjoining the first buffer chamber (221), which can be separated from the buffer chamber (221) by means of a second insertion gate (264),
- a second buffer chamber (222) adjoining the process chamber (235), which can be separated from the process chamber (235) by means of a third insertion gate (265),
- a discharge chamber (240) adjoining the second buffer chamber (222) and having an outlet port (263), which can be separated from the second buffer chamber (222) by means of a fourth insertion gate (262), wherein the introduction chamber (220), the first buffer chamber (221), the second buffer chamber (222) and the discharge chamber (240) are designed as a module for receiving substrates up to a predetermined size,
wherein the substrates (200) for the coating are transportable from the introduction chamber (220) through the first buffer chamber (221) to the process chamber (235) and from the process chamber (235) through the second buffer chamber (222) to the discharge chamber (240),
**characterized in that**
the first buffer chamber (221) has a gap sluice device with at least one slit diaphragm (221b) by means of which, when the first insertion gate (261) is open or closed, within the first buffer chamber (221) a pressure gradient is adjustable between the pressure in the region of the second insertion gate (264) and the pressure in the region of the first insertion gate (261) and
**in that** the inline coating installation comprises pumps connected to the buffer chamber (221), wherein also when the insertion gate (260) is open and the first insertion gate (261) is open, a pressure gradient between the pressure in the region of the second insertion gate (264) and the pressure in the region of the first insertion gate (261) can be maintained by operating pumps within the buffer chamber (221).

## Revendications

1. Procédé de fonctionnement d'une installation de revêtement en ligne, comprenant :
- une chambre d'introduction (220), avec une porte d'introduction (260),
- une première chambre tampon (221) adjacente à la chambre d'introduction (220), séparable de la chambre d'introduction (220) par une première porte de séparation (261),
- une chambre de traitement (235) adjacente à la première chambre tampon (221), séparable de la chambre tampon (221) par une deuxième porte de séparation (264),
- une deuxième chambre tampon (222) adjacente à la chambre de traitement (235), séparable de la chambre de traitement (235) au moyen d'une troisième porte de séparation (265),
- une chambre de sortie (240) adjacente à la deuxième chambre tampon (222) et avec une porte de sortie (263), séparable de la deuxième chambre tampon (222) par une quatrième porte de séparation (262), la chambre d'introduction (220), la première chambre tampon (221), la deuxième chambre tampon (222) et la chambre de sortie (240) étant réalisées comme module pour la réception de substrats jusqu'à une grandeur définie, les substrats (200) étant transportés pour être revêtus de la chambre d'introduction (220) à la chambre de traitement (235) en passant par la première chambre tampon (221), et de la chambre de traitement (235) à la chambre de sortie (240) en passant par la deuxième chambre tampon (222),
**caractérisé**
**en ce que** la première chambre tampon (221) comprend un dispositif de sas à fente avec au moins un diaphragme à fente (221b), au moyen duquel, la première porte de séparation (261) étant ouverte ou fermée, un gradient de pression est réglé à l'intérieur de la première chambre tampon (221) entre la pression au niveau de la deuxième porte de séparation (264) et la pression au niveau de la première porte de séparation (261), et
**en ce que**, même en cas de porte d'introduction (260) ouverte et de première porte de séparation (261) ouverte, un gradient de pression est maintenu à l'intérieur de la chambre tampon (221) entre la pression au niveau de la deuxième porte de séparation (264) et la pression au niveau de la première porte de séparation (261) par mise en service de pompes reliées à la chambre tampon (221).

2. Procédé selon la revendication 1, **caractérisé en ce que** pour le revêtement de substrats plus petits que les modules,
- la première porte de séparation (261) est fermée,
- la porte d'introduction (260) est ouverte,
- un substrat est transporté dans la chambre d'introduction (220),
- la porte d'introduction (260) est fermée,
- la chambre d'introduction (220) est évacuée jusqu'à une pression définie,
- la première porte de séparation (261) est ouverte,
- le substrat est transporté dans la chambre tampon (221), une pression inférieure à celle dans la chambre d'introduction (220) étant réglée dans la chambre tampon (221) au niveau de la porte de séparation (264),
- la première porte de séparation (261) est refermée,
- la chambre tampon (221) est évacuée jusqu'à une pression de transfert et la deuxième porte de séparation (264) est ouverte,
- le substrat est transporté dans la chambre de traitement (235),
- la deuxième porte de séparation (264) est fermée et le substrat est traité dans la chambre de traitement (235).

3. Procédé selon la revendication 1, **caractérisé en ce que** pour le revêtement de substrats plus grands que les modules,
- la porte d'introduction (260) et la première porte de séparation (261) sont ouvertes,
- un substrat est transporté dans la chambre d'introduction (220) et la chambre tampon (221), une pression inférieure à celle dans la chambre d'introduction (220) étant réglée dans la chambre tampon (221) au niveau de la porte de séparation (264),
- la porte d'introduction (260) est fermée,
- la chambre d'introduction (220) est évacuée jusqu'à une pression définie,
- la chambre tampon (221) est évacuée jusqu'à une pression de transfert au niveau de la deuxième porte de séparation (264),
- la deuxième porte de séparation (264) est ouverte et le substrat (200) est transporté dans la chambre de traitement (235) pour y être traité.

4. Procédé selon la revendication 3, **caractérisé en ce que** la première porte de séparation (261) est fermée après que le substrat (200) a dépassé la première porte de séparation (261) par son bord arrière (200a), la deuxième porte de séparation (264) n'ayant pas encore été dépassée par le bord arrière (200a).

5. Procédé selon la revendication 4, **caractérisé en ce que** la deuxième porte de séparation (264) est fermée après que le substrat (200) a dépassé la deuxième porte de séparation (264) par son bord arrière (200a).

6. Procédé selon la revendication 5, **caractérisé en ce que** la première porte de séparation (261) est ouverte après que le substrat (200) a dépassé la deuxième porte de séparation (264) par son bord arrière (200a).

7. Procédé selon l'une des revendications précédentes, **caractérisé en ce qu'**une pression inférieure à la pression atmosphérique est réglée même en cas de porte d'introduction (260) et de première porte de séparation (261) ouvertes à l'intérieur de la chambre tampon (221) au niveau de la deuxième porte de séparation (264).

8. Procédé selon l'une des revendications précédentes, **caractérisé en ce qu'**une évacuation continue de la chambre tampon (221) est effectuée au moyen de pompes reliées à la chambre tampon (221).

9. Procédé selon l'une des revendications précédentes, **caractérisé en ce qu'**un gradient de pression est réglé à l'intérieur de la chambre tampon (221) entre la pression au niveau de la deuxième porte de séparation (264) et la pression au niveau de la première porte de séparation (261), la pression au niveau de la deuxième porte de séparation (264) étant au moins 2 fois inférieure à la pression au niveau de la première porte de séparation (261).

10. Installation de revêtement en ligne, comprenant
- une chambre d'introduction (220), avec une porte d'introduction (260),
- une première chambre tampon (221) adjacente à la chambre d'introduction (220), séparable de la chambre d'introduction (220) par une première porte de séparation (261),
- une chambre de traitement (235) adjacente à la première chambre tampon (221), séparable de la chambre tampon (221) par une deuxième porte de séparation (264),
- une deuxième chambre tampon (222) adjacente à la chambre de traitement (235), séparable de la chambre de traitement (235) au moyen d'une troisième porte de séparation (265),
- une chambre de sortie (240) adjacente à la deuxième chambre tampon (222) et avec une porte de sortie (263), séparable de la deuxième chambre tampon (222) par une quatrième porte de séparation (262), la chambre d'introduction (220), la première chambre tampon (221), la deuxième chambre tampon (222) et la chambre de sortie (240) étant réalisées comme module pour la réception de substrats jusqu'à une grandeur définie, les substrats (200) étant transportables pour être revêtus de la chambre d'introduction (220) à la chambre de traitement (235) en passant par la première chambre tampon (221), et de la chambre de traitement (235) à la chambre de sortie (240) en passant par la deuxième chambre tampon (222),
**caractérisée**
**en ce que** la première chambre tampon (221) comprend un dispositif de sas à fente avec au moins un diaphragme à fente (221b), au moyen duquel, la première porte de séparation (261) étant ouverte ou fermée, un gradient de pression est réglable à l'intérieur de la première chambre tampon (221) entre la pression au niveau de la deuxième porte de séparation (264) et la pression au niveau de la première porte de séparation (261), et
**en ce que** l'installation de revêtement en ligne comprend des pompes reliées à la chambre tampon (221), un gradient de pression entre la pression au niveau de la deuxième porte de séparation (264) et la pression au niveau de la première porte de séparation (261) pouvant être maintenu par mise en service des pompes à l'intérieur de la chambre tampon (221), même en cas de porte d'introduction (260) ouverte et de première porte de séparation (261) ouverte.
